(19) Europäisches Patentamt

European Patent Office

Office européen des brevets

(11) **EP 4 756 439 A1**

(12) **EUROPEAN PATENT APPLICATION**

(43) Date of publication:
**10.06.2026 Bulletin 2026/24**

(21) Application number: 25220365.8

(22) Date of filing: **03.12.2025**

(51) International Patent Classification (IPC):
**G01R 27/02** (2006.01)    **G01R 27/18** (2006.01)
**G01R 31/52** (2020.01)    **H02S 50/10** (2014.01)

(52) Cooperative Patent Classification (CPC):
**G01R 27/025; G01R 27/18; G01R 31/52;
H02S 50/10**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **04.12.2024  CN 202411774334**

(71) Applicant: **SolaX Power Network
Technology (Zhejiang) Co., Ltd.
Zhejiang 311599 (CN)**

(72) Inventors:
• **CHEN, Jianming
  Hangzhou (CN)**
• **LI, Xinfu
  Hangzhou (CN)**
• **JIANG, Fei
  Hangzhou (CN)**
• **XIAO, Yongli
  Hangzhou (CN)**

(74) Representative: **Zhu, Puxing
Mars Universe IP
c/o Spaces
Mühldorfstraße 8
81671 München (DE)**

(54) **METHOD, DEVICE, SYSTEM, AND STORAGE MEDIUM FOR INSULATION IMPEDANCE DETECTION**

(57)    A method, device, system, and storage medium for insulation impedance detection are provided. The method includes: determining a preliminary inspection insulation impedance of each of the power supply units; determining a preliminary inspection insulation impedance that meets a preset condition as a target insulation impedance based on the preliminary inspection insulation impedance of each of the power supply units; determining an insulation inspection compensation coefficient based on the target insulation impedance and initial impedances of the plurality of power supply units; and determining a secondary inspection insulation impedance of a target power supply unit based on the insulation inspection compensation coefficient.

```
┌──────────────────────────────────────────┐
│ determining a preliminary inspection      │ ⌇ S501
│ insulation impedance of each power supply  │
│ unit                                       │
└──────────────────────────────────────────┘
                    │
                    ▼
┌──────────────────────────────────────────┐
│ determining a preliminary inspection      │ ⌇ S502
│ insulation impedance that meets a preset   │
│ condition as a target insulation impedance │
│ based on the preliminary inspection        │
│ insulation impedance of each power supply  │
│ unit                                       │
└──────────────────────────────────────────┘
                    │
                    ▼
┌──────────────────────────────────────────┐
│ determining an insulation inspection       │ ⌇ S503
│ compensation coefficient of the target     │
│ power supply unit based on the target      │
│ insulation impedance and the initial       │
│ impedances of the power supply units       │
└──────────────────────────────────────────┘
                    │
                    ▼
┌──────────────────────────────────────────┐
│ determining a secondary inspection         │ ⌇ S504
│ insulation impedance corresponding to the  │
│ target power supply unit based on the      │
│ insulation inspection compensation         │
│ coefficient                                │
└──────────────────────────────────────────┘
```

FIG. 5

EP 4 756 439 A1

**Description**

**TECHNICAL FIELD**

This invention relates to the technical field of power supply, and more specifically to a method, device, system, and storage medium for insulation impedance detection.

**BACKGROUND**

Currently, photovoltaic (PV) power generation systems can convert solar radiation energy into electrical energy using solar cell modules. An inverter then converts the direct current (DC) into sinusoidal alternating current (AC) that is in phase and frequency with the grid voltage, ultimately reducing the grid load after being connected to the grid. However, to prevent the risk of electric shock caused by contact with PV arrays, current standards require that the PV arrays have good insulation performance to ground. Therefore, it is usually required to measure the DC insulation impedance between the PV arrays and ground before activating the PV power generation system. The system is only allowed to start operating when the insulation impedance of all PV arrays to ground meets the requirements; otherwise, a fault should be indicated and grid connection should be restricted.

In related technologies, insulation impedance measurement generally employs the Bridge balancing method. A Bridge branch consisting of a known-value resistor and a controllable switch is constructed between the positive output terminal and ground or the negative output terminal and ground of the photovoltaic array. By controlling the on and off of the switch, the insulation impedance distribution of the photovoltaic array to ground is altered, and the insulation impedance to ground of the positive and negative output terminals of the photovoltaic array can be calculated by solving a system of two equations. However, since a photovoltaic power generation system typically includes n photovoltaic arrays, and the conventional Bridge balancing method can only measure the insulation impedance value of a single photovoltaic array, it requires constructing n Bridge branches in hardware, each connected between the output terminals of the n photovoltaic arrays and ground. This results in an exceptionally complex insulation impedance detection circuit.

**SUMMARY**

This invention provides method, device, system, and storage medium for insulation impedance detection, aiming to solve the above-mentioned technical problems.

The scope of protection of this invention is defined by the appended independent claims. Improvements thereof are specified in the dependent claims.

In a first aspect, the present invention provides a method for insulation impedance detection, applicable to a power supply system including a plurality of power supply units connected in parallel between a positive direct current (DC) bus and a negative DC bus, where the method includes:

> determining a preliminary inspection insulation impedance of each of the power supply units;
> determining a preliminary inspection insulation impedance that meets a preset condition as a target insulation impedance based on the preliminary inspection insulation impedance of each of the power supply units;
> determining an insulation inspection compensation coefficient based on the target insulation impedance and initial impedances of the plurality of power supply units; and
> determining a secondary inspection insulation impedance of a target power supply unit based on the insulation inspection compensation coefficient;
> wherein the preliminary inspection insulation impedance of any of the power supply units has an impedance value determined on an assumption that a voltage between the negative DC bus and a ground terminal is only influenced by the power supply unit;
> the secondary inspection insulation impedance has an impedance value determined by the insulation inspection compensation coefficient compensating for an influence of other ones of the power supply units on the voltage between the negative DC bus and the ground terminal.

In a second aspect, the present invention provides a device for insulation impedance detection, including:

> a preliminary inspection module configured to determine a preliminary inspection insulation impedance of each of the power supply units;
> an abnormal impedance determination module configured to determine a preliminary inspection insulation impedance that meets a preset condition as a target insulation impedance based on the preliminary inspection insulation impedance of each of the power supply units;

a compensation determination module configured to determine an insulation inspection compensation coefficient based on the target insulation impedance and initial impedances of the power supply units; and

a secondary inspection module configured to determine a secondary inspection insulation impedance of a target power supply unit based on the insulation inspection compensation coefficient;

wherein the preliminary inspection insulation impedance of any of the power supply units has an impedance value determined on an assumption that a voltage between the negative DC bus and a ground terminal is only influenced by the power supply unit;

the secondary inspection insulation impedance has an impedance value determined by the insulation inspection compensation coefficient compensating for an influence of other ones of the power supply units on the voltage between the negative DC bus and the ground terminal.

In a third aspect, the present invention provides a system for insulation impedance detection, including a memory and a processor, the memory having stored thereon computer programs, which when executed by the processor, cause the processor to implement the method for insulation impedance detection according to the first aspect.

In a fourth aspect, the present invention provides a storage medium, having stored thereon a plurality of instructions executable by a processor, wherein the instructions when executed by the processor cause the processor to implement the method for insulation impedance detection according to the first aspect.

According to the present invention, after determining the preliminary inspection insulation impedance of each power supply unit, one or more of the preliminary inspection insulation impedances that meets the preset condition can be selected as the target insulation impedance of the target power supply unit, and the insulation inspection compensation coefficient can be used to compensate for the target insulation impedance, thereby determining the secondary inspection insulation impedance corresponding to the target power supply unit.

Since the preliminary inspection insulation impedance of any power supply unit is determined by assuming that the voltage between the negative DC bus and the ground terminal is only affected by the power supply unit, the same bridge circuit can be used to measure the preliminary inspection insulation impedance of each power supply unit. This avoids the problem of having to construct n bridge circuits between the output terminals of n photovoltaic arrays and ground, which would make the insulation impedance detection circuit extremely complex.

Meanwhile, since the secondary inspection insulation impedance is the impedance value determined by compensating for the degree of influence of other power supply units on the voltage between the negative DC bus and the ground terminal based on the insulation inspection compensation coefficient, the secondary inspection insulation impedance is the actual impedance value determined under the influence of all power supply units on the voltage between the negative DC bus and the ground terminal. Therefore, the accuracy of the insulation impedance measurement can be guaranteed.

In other words, this invention measures the preliminary inspection insulation impedance of each power supply unit using the same bridge circuit. After finding out abnormal preliminary inspection insulation impedances, the insulation impedance corresponding to the target power supply unit is re-determined based on the insulation inspection compensation coefficient. This not only avoids the problem of constructing n bridge branches between the output terminals of n photovoltaic arrays and ground, which would make the insulation impedance detection circuit extremely complex, but also ensures the accuracy of insulation impedance measurement.

## BRIEF DESCRIPTION OF THE DRAWINGS

To more clearly illustrate the technical solutions in the embodiments of the present invention, the accompanying drawings used in the description of the embodiments will be briefly introduced below. The accompanying drawings described below are only some embodiments of the present invention. For those skilled in the art, other drawings can be obtained based on these drawings without creative effort.

FIG. 1 shows a schematic diagram of a power supply system according to an embodiment of the present invention.
FIG. 2 shows a schematic diagram of the power supply system according to another embodiment of the present invention.
FIG. 3 shows a schematic diagram of the power supply system according to another embodiment of the present invention.
FIG. 4 shows a schematic diagram of the power supply system according to another embodiment of the present invention.
FIG. 5 shows a schematic flowchart of a method for insulation impedance detection according to an embodiment of the present invention.
FIG. 6 shows a schematic diagram of an ideal equivalent circuit for detecting the preliminary inspection insulation impedance according to an embodiment of the present invention.

FIG. 7 shows a schematic diagram of an actual equivalent circuit for detecting insulation impedance according to an embodiment of the present invention.

FIG. 8 shows a schematic diagram of a process for determining the preliminary inspection insulation impedance according to an embodiment of the present invention.

FIG. 9 shows a schematic diagram of a process for determining the secondary inspection insulation impedance according to an embodiment of the present invention.

FIG. 10 shows a schematic diagram of a process for determining the initial impedance according to an embodiment of the present invention.

FIG. 11 shows a schematic diagram of an equivalent circuit for detecting initial impedance according to an embodiment of the present invention.

FIG. 12 shows a schematic diagram of a device for insulation impedance detection according to an embodiment of the present invention.

List of reference signs:

10: power supply unit, 20: first bridge, 30: second bridge, $S_1$: first switch, $S_2$: second switch, BUS+: positive DC bus, BUS-: negative DC bus, PE: ground terminal.

## DETAILED DESCRIPTION

The technical solutions of the embodiments of the present invention will be clearly and completely described below with reference to the accompanying drawings. The described embodiments are only some embodiments of the present invention, and not all embodiments. Based on the embodiments of the present invention, all other embodiments obtained by those skilled in the art without creative effort are within the scope of protection of the present invention.

In the description of this invention, the term "exemplary" is used to mean "serving as an example, illustration, or description." Any embodiment described as "exemplary" in this invention is not necessarily to be construed as being more preferred or advantageous than other embodiments. The following description is provided to enable any person skilled in the art to make and use the invention. Details are set forth in the following description for purposes of explanation. It should be understood that those skilled in the art will recognize that the invention can be made without using these specific details. In other instances, well-known structures and processes will not be described in detail to avoid obscuring the description of the invention with unnecessary detail. Therefore, the invention is not intended to be limited to the embodiments shown, but is consistent with the broadest scope accorded to the principles and features disclosed herein.

This invention provides a method, device, system, and storage medium for insulation impedance detection, which will be described in detail below.

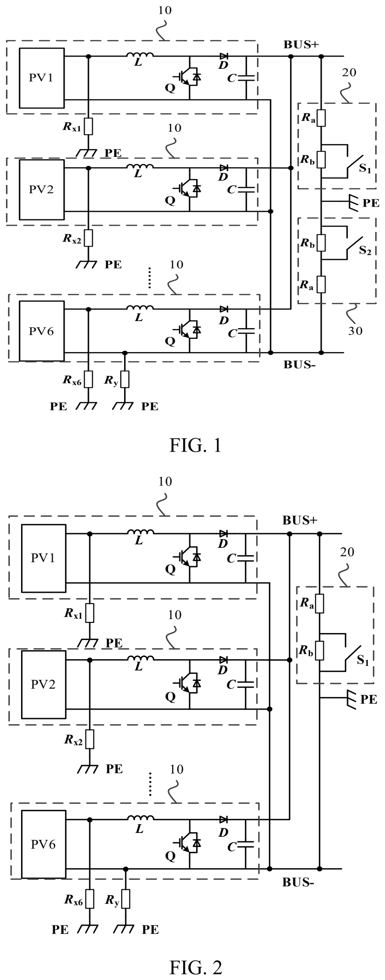

Before introducing the method for insulation impedance detection of the present invention, a power supply system for performing insulation impedance detection is first introduced. Referring to FIG. 1, which shows a schematic diagram of a power supply system according to an embodiment of the present invention. The power supply system includes a plurality of power supply units 10 connected in parallel between the positive DC bus BUS+ and the negative DC bus BUS-, a first bridge 20 connected between the positive DC bus BUS+ and the ground terminal PE, and a second bridge 30 connected between the negative DC bus BUS- and the ground terminal PE.

Specifically, the power supply unit 10 can output a DC voltage. After the inverter converts the DC voltage of the power supply unit 10 into a sinusoidal AC current with the same frequency and phase as the grid voltage, the power supply unit 10 can be connected to the grid to reduce the grid load. For example, the power supply unit 10 can be, but is not limited to, energy storage batteries such as lead-acid batteries, lithium-ion batteries, sodium-sulfur batteries, nickel-metal hydride batteries, nickel-cadmium batteries, and lithium iron phosphate batteries.

In some embodiments of the present invention, the power supply unit 10 may further include a DC-DC converter. For example, in FIG. 1, each power supply unit 10 includes a boost circuit BOOST composed of an inductor L, a switching transistor Q, a diode D, and a capacitor C. The boost circuit BOOST can increase the output DC voltage of the energy storage battery before outputting it, so as to ensure that the output voltage of the power supply unit 10 meets the requirements. It is understood that the power supply unit 10 may also include a buck convertor circuit (step-down convertor circuit) BUCK or a BOOST-BUCK circuit to control the magnitude of the DC voltage output by the power supply unit 10.

It should be noted that the insulation impedance of the plurality of power supply units 10 includes the impedance between the positive output terminal of each power supply unit 10 and the ground terminal PE, as well as the impedance between the negative output terminals of the plurality of power supply units 10 and the ground terminal PE. Taking FIG. 1 as an example, the insulation impedance between the positive output terminal of the energy storage battery PV1 and the ground terminal PE is equivalent to an impedance $R_{x1}$, the insulation impedance between the positive output terminal of the energy storage battery PV2 and the ground terminal PE is equivalent to an impedance $R_{x2}$, and so on. The insulation impedance between the positive output terminal of the energy storage battery PV6 and the ground terminal PE is equivalent to an impedance $R_{x6}$, and the insulation impedance between the negative output terminals of the energy storage batteries PV1~PV6 and the ground terminal PE is equivalent to an impedance $R_y$.

The impedance of the first bridge 20 and/or the second bridge 30 can be changed by control during the measurement process. When the impedance of the first bridge 20 and/or the second bridge 30 is changed, the voltage between the negative DC bus BUS- and the ground terminal PE will change. Therefore, by measuring the voltage between the negative DC bus BUS- and the ground terminal PE, an equation related to the insulation impedance can be constructed, so that the insulation impedance of the power supply unit 10 can be calculated by solving the equation.

Taking FIG. 1 as an example, the first bridge 20 includes a first resistor and a second resistor connected in series between the positive DC bus BUS+ and the ground terminal PE, and a first switch $S_1$ connected in parallel with the second resistor. The resistance values of the first resistor and the second resistor are known. When the first switch $S_1$ changes its operating state, the impedance of the first bridge 20 can be changed. For example, when the first switch $S_1$ changes from a closed state to an open state, the impedance of the first bridge 20 changes from the sum of the impedance values of the first resistor and the second resistor to the resistance value of the first resistor. As another example, when the first switch $S_1$ changes from an open state to a closed state, the impedance of the first bridge 20 changes from the resistance value of the first resistor to the sum of the impedance values of the first resistor and the second resistor.

The second bridge 30 includes a third resistor and a fourth resistor connected in series between the negative DC bus BUS- and the ground terminal PE, and a second switch $S_2$ connected in parallel with the fourth resistor. Changing the operating state of the second switch $S_2$ changes the impedance of the first bridge 20. For example, when the second switch $S_2$ changes from a closed state to an open state, the impedance of the second bridge 30 changes from the sum of the resistance values of the third and fourth resistors to the resistance value of the third resistor. As another example, when the second switch $S_2$ changes from an open state to a closed state, the impedance of the second bridge 30 changes from the resistance value of the third resistor to the sum of the resistance values of the third and fourth resistors.

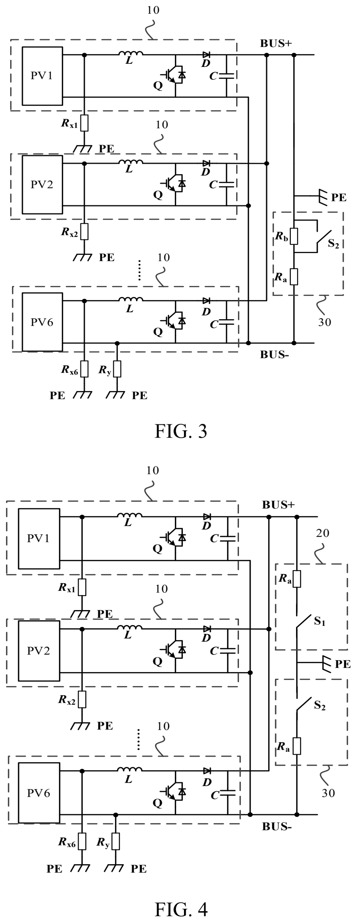

It should be noted that, for ease of calculating insulation impedance, in FIG. 1, the first and third resistors are both implemented as resistors $R_a$, and the second and fourth resistors are both implemented as resistors $R_b$. In some possible embodiments, the resistance values of the first and third resistors may not be equal, and the resistance values of the second and fourth resistors may also not be equal. Furthermore, when using high-precision measuring equipment to measure the voltage between the negative DC bus BUS-and the ground terminal PE, the power supply system may only include the first bridge 20 or the second bridge 30. For example, referring to FIG. 2, which shows a schematic diagram of the power supply system according to another embodiment of the present invention, the power supply system only includes the first bridge 20 composed of the first resistor, the second resistor, and the first switch $S_1$. For another example, referring to FIG. 3, which shows a schematic diagram of the power supply system according to another embodiment of the present invention, the power supply system only includes the second bridge 30 composed of the third resistor, the fourth resistor, and the second switch $S_2$.

It should be noted that the above description of the power supply system is intended to clearly illustrate the implementation of the present invention. Those skilled in the art can also make equivalent modifications to the power supply system under the guidance of the present invention. For example, referring to FIG. 4, which shows a schematic diagram of the power supply system according to another embodiment of the present invention, wherein the first bridge 20 includes a first resistor and a first switch $S_1$ connected in series between the positive DC bus BUS+ and the ground terminal PE, and the second bridge 30 includes a second resistor and a second switch $S_2$ connected in series between the negative DC bus BUS- and the ground terminal PE.

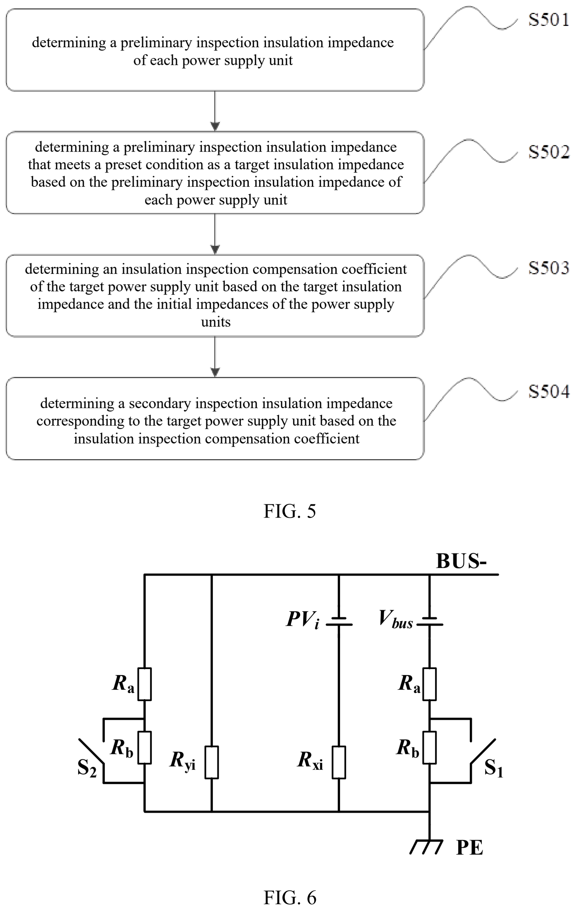

The following describes the method for insulation impedance detection of the present invention. This method can be applied to the power supply system described in any of the above embodiments. Referring to FIG. 5, which shows a schematic flowchart of a method for insulation impedance detection according to an embodiment of the present invention. The method for insulation impedance detection includes:

S501, determining a preliminary inspection insulation impedance of each power supply unit 10.

Specifically, the preliminary inspection insulation impedance of each power supply unit 10 is an impedance value determined by assuming that the voltage between the negative DC bus BUS- and the ground terminal PE is only affected by that power supply unit 10. In other words, when determining the preliminary inspection insulation impedance of each power supply unit 10, it is assumed that open circuits are formed between the positive output terminal of other power supply units 10 and the ground terminal PE. Therefore, the preliminary inspection insulation impedance is an ideal measurement value rather than an actual insulation impedance value.

For example, taking FIG. 1 as an example, during the measurement of insulation impedance, the switching transistor Q is in the off state. Assuming that the positive output terminals of other power supply units 10 are open-circuited with the ground terminal PE, according to Thevenin's theorem, FIG. 1 can be simplified to the circuit diagram shown in FIG. 6. In FIG. 6, $PV_i$ is the output voltage of the corresponding power supply unit 10, $R_{xi}$ is the insulation impedance between the positive output terminal of the power supply unit 10 and the ground terminal PE, $R_{yi}$ is the insulation impedance between the negative output terminal of the power supply unit 10 and the ground terminal PE, and $V_{bus}$ is the bus voltage between the positive DC bus BUS+ and the negative DC bus BUS-.

As can be seen, when the positive output terminals of other power supply units 10 are open-circuited with the ground terminal PE, the first bridge 20 and the second bridge 30 can be considered as bridges for the measurement of the insulation impedance of the power supply unit 10. Therefore, the preliminary inspection insulation impedance of the power supply unit 10 can be determined by using the bridge balance method. The measurement process of other power supply units 10 is the same. Assuming that the positive output terminals of the remaining power supply units 10 are open-circuited with the ground terminal PE, the preliminary inspection insulation impedance of the corresponding power supply units 10 can be calculated. This will not be elaborated further here.

S502, determining a preliminary inspection insulation impedance that meets a preset condition as a target insulation impedance based on the preliminary inspection insulation impedance of each power supply unit 10.

After determining the preliminary inspection insulation impedance of each power supply unit 10, one or more of the preliminary inspection insulation impedances that meets the preset condition can be selected as the target insulation impedance of the target power supply unit 10. The target power supply unit 10 is the power supply unit 10 corresponding to the preliminary inspection insulation impedance that meets the preset condition. For example, taking FIG. 1 as an example, assuming that the preliminary inspection insulation impedance that meets the preset condition corresponds to the preliminary inspection impedance value of resistor $R_{x1}$, then the power supply unit 10 for the output voltage $PV_1$ is the target power supply unit 10.

In some embodiments of the present invention, the preliminary inspection insulation impedances of a plurality of power supply units 10 can be determined as the target insulation impedance. For example, the preliminary inspection insulation impedances of the plurality of power supply units 10 whose impedance values are within a certain impedance range can be used as the target insulation impedance. In other embodiments of the present invention, selecting one or more of the preliminary inspection insulation impedances that meets the preset condition as the target insulation impedance based on the preliminary inspection insulation impedance of each power supply unit 10 includes: determining the preliminary inspection insulation impedance of one power supply unit 10 as the target insulation impedance. For example, the smallest of the preliminary inspection insulation impedances of multiple power supply units 10 can be determined as the target insulation impedance.

It is understood that those skilled in the art can set the preset condition according to actual needs to measure the insulation impedance of the power supply unit 10 that meets the conditions, and the present invention does not make specific limitations.

S503, determining an insulation inspection compensation coefficient of the target power supply unit 10 based on the target insulation impedance and the initial impedances of the power supply units 10.

After determining the target insulation impedance, the insulation inspection compensation coefficient can be determined based on the target insulation impedance and the initial impedances of the power supply units 10, so as to compensate for the influence of other power supply units 10 on the voltage between the negative DC bus BUS- and the ground terminal PE according to the insulation inspection compensation coefficient.

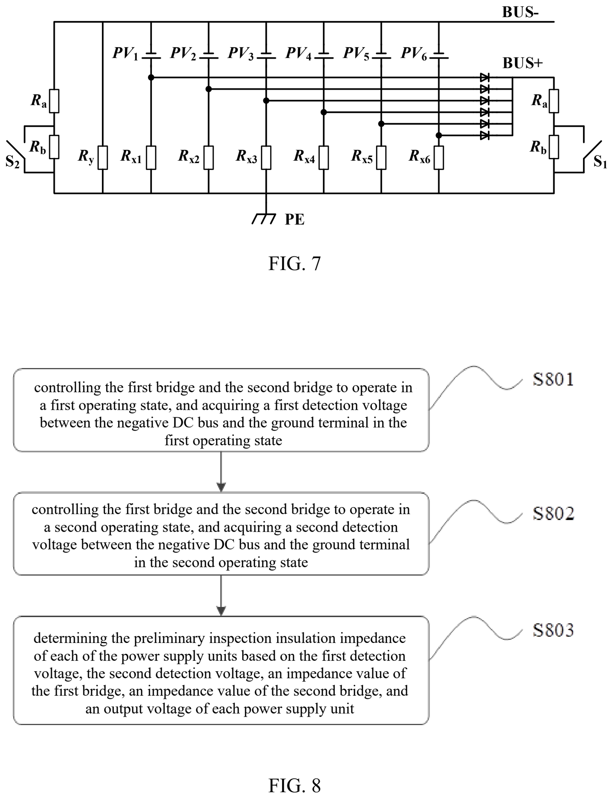

It should be noted that, in practice, the voltage between the negative DC bus BUS- and the ground terminal PE is affected by each power supply unit 10. That is, the positive output terminals of other power supply units 10 are not open-circuited with the ground terminal PE. Therefore, according to Thevenin's theorem, the simplified actual circuit diagram of FIG. 1 can be shown in FIG. 7. For FIG. 7, according to the voltage superposition theorem (that is, the response (voltage or current) of any branch of a bilateral linear circuit with multiple independent sources is equal to the algebraic sum of the responses of each independent source acting alone), assuming that the insulation impedances of other power supply units 10 are normal (that is, the insulation impedances of other power supply units 10 are the known initial impedances measured after system installation), the insulation inspection compensation coefficient can be calculated by the following formula:

$$k_{eq} = 1 + \cfrac{\cfrac{R_{x0}}{5}}{\cfrac{1}{\cfrac{1}{R_{xi}} + \cfrac{1}{R_{yi}} + \cfrac{1}{R_a} + \cfrac{1}{R_a}}}$$

where $R_{x0}$ is the initial impedance of power supply unit 10, $R_{xi}$ and $R_{yi}$ are the target insulation impedances, and $R_a$ is the resistance value of the first resistor and the third resistor.

S504, determining a secondary inspection insulation impedance corresponding to the target power supply unit 10 based on the insulation inspection compensation coefficient.

After determining the insulation inspection compensation coefficient, the insulation inspection compensation coefficient can be used to compensate for the influence of other power supply units 10 on the voltage between the negative DC bus BUS- and the ground terminal PE, so as to correct the voltage components of other power supply units 10 between the negative DC bus BUS- and the ground terminal PE, thereby determining the secondary inspection insulation impedance of the target power supply unit 10 that conforms to the actual situation.

In this embodiment of the invention, since the preliminary inspection insulation impedance of any power supply unit 10 is determined by assuming that the voltage between the negative DC bus BUS- and the ground terminal PE is only affected by the power supply unit 10, the same bridge circuit can be used to measure the preliminary inspection insulation impedance of each power supply unit 10. This avoids the problem of needing to construct n bridge branches between the output terminals of n photovoltaic arrays and ground, which would make the insulation impedance detection circuit extremely complex.

Meanwhile, since the secondary inspection insulation impedance is the impedance value determined by compensating for the influence of other power supply units 10 on the voltage between the negative DC bus BUS- and the ground terminal PE based on the insulation inspection compensation coefficient, the secondary inspection insulation impedance is the actual impedance value determined under the influence of all power supply units 10 on the voltage between the negative DC bus BUS- and the ground terminal PE, which can ultimately ensure the accuracy of the insulation impedance measurement.

In other words, the present invention measures the preliminary inspection insulation impedance of each power supply unit 10 using the same bridge circuit. After screening out abnormal preliminary inspection insulation impedances, the insulation impedance corresponding to the target power supply unit 10 is re-determined by using the insulation inspection compensation coefficient. This not only avoids the problem of constructing n bridge branches between the output terminals of n photovoltaic arrays and ground, which would make the insulation impedance detection circuit extremely complex, but also ensures the accuracy of insulation impedance measurement.

In some embodiments of the present invention, for example, the power supply system further includes a first bridge 20 connected between the positive DC bus BUS+ and the ground terminal PE, and a second bridge 30 connected between the negative DC bus BUS- and the ground terminal PE. Referring to FIG. 8, which shows a schematic diagram of a process for determining the preliminary inspection insulation impedance according to an embodiment of the present invention, wherein determining the preliminary inspection insulation impedance of each power supply unit 10 includes:

S801, controlling the first bridge 20 and the second bridge 30 to operate in a first operating state, and acquiring a first detection voltage between the negative DC bus BUS- and the ground terminal PE in the first operating state;
S802, controlling the first bridge 20 and the second bridge 30 to operate in a second operating state, and acquiring a second detection voltage between the negative DC bus BUS- and the ground terminal PE in the second operating state; and
S803, determining the preliminary inspection insulation impedance of each power supply unit 10 based on the first detection voltage, the second detection voltage, the impedance value of the first bridge 20, the impedance value of the second bridge 30, and the output voltage of each power supply unit 10.

It should be noted that at least one of the first bridge 20 and the second bridge 30 has different impedance values in the first operating state and the second operating state. Therefore, the first detection voltage and the second detection voltage are also different. Thus, two equations can be constructed and the insulation impedance can be solved for each power supply unit 10.

For example, taking FIG. 1 as an example, the first bridge 20 includes a first resistor and a second resistor connected in series between the positive DC bus BUS+ and the ground terminal PE, and a first switch $S_1$ connected in parallel with the second resistor. The second bridge 30 includes a third resistor and a fourth resistor connected in series between the negative DC bus BUS- and the ground terminal PE, and a second switch $S_2$ connected in parallel with the fourth resistor. If at least one of the first switch $S_1$ and the second switch $S_2$ has a different switching state in the first operating state and the second operating state, then the impedance values of at least one of the first bridge 20 and the second bridge 30 will be different in the first operating state and the second operating state.

Assuming that in the first operating state, the first switch $S_1$ of the first bridge 20 is in a closed state and the second switch $S_2$ of the second bridge 30 is in a closed state, then the measured first detection voltage can be calculated according to the following formula:

$$f_{11}: \quad \frac{\dfrac{1}{\dfrac{1}{R_{xi}} + \dfrac{1}{R_{yi}} + \dfrac{1}{R_a}}}{R_a + \dfrac{1}{\dfrac{1}{R_{xi}} + \dfrac{1}{R_{yi}} + \dfrac{1}{R_a}}} \times V_{bus} + \frac{\dfrac{1}{\dfrac{1}{R_a} + \dfrac{1}{R_{yi}} + \dfrac{1}{R_a}}}{R_{xi} + \dfrac{1}{\dfrac{1}{R_a} + \dfrac{1}{R_{yi}} + \dfrac{1}{R_a}}} \times PV_i = V_{E10}$$

wherein $V_{E10}$ is the first detection voltage, $R_{xi}$ and $R_{yi}$ are the preliminary inspection insulation impedances of any power supply unit 10, $P_{Vi}$ is the output voltage of any power supply unit 10, $V_{bus}$ is the bus voltage, and $R_a$ is the resistance value of the first resistor and the third resistor.

Assuming that in the second operating state, the first switch $S_1$ of the first bridge 20 is in a closed state and the second switch $S_2$ of the second bridge 30 is in an open state, then the measured second detection voltage can be calculated according to the following formula:

$$f_{12}: \quad \frac{\dfrac{1}{\dfrac{1}{R_{xi}} + \dfrac{1}{R_{yi}} + \dfrac{1}{R_a + R_b}}}{R_a + \dfrac{1}{\dfrac{1}{R_{xi}} + \dfrac{1}{R_{yi}} + \dfrac{1}{R_a + R_b}}} \times V_{bus} + \frac{\dfrac{1}{\dfrac{1}{R_a} + \dfrac{1}{R_{yi}} + \dfrac{1}{R_a + R_b}}}{R_{xi} + \dfrac{1}{\dfrac{1}{R_a} + \dfrac{1}{R_{yi}} + \dfrac{1}{R_a + R_b}}} \times PV_i = V_{E11}$$

wherein $V_{E11}$ is the second detection voltage, and $R_b$ is the resistance value of the second resistor and the fourth resistor.
In another example, assuming that in the second operating state, the first switch $S_1$ of the first bridge 20 is in an open state and the second switch $S_2$ of the second bridge 30 is in a close state, then the measured second detection voltage can be calculated according to the following formula:

$$f_{13}: \quad \frac{\dfrac{1}{\dfrac{1}{R_{xi}} + \dfrac{1}{R_{yi}} + \dfrac{1}{R_a}}}{R_a + R_b + \dfrac{1}{\dfrac{1}{R_{xi}} + \dfrac{1}{R_{yi}} + \dfrac{1}{R_a}}} \times V_{bus} + \frac{\dfrac{1}{\dfrac{1}{R_a} + \dfrac{1}{R_{yi}} + \dfrac{1}{R_a + R_b}}}{R_{xi} + \dfrac{1}{\dfrac{1}{R_a} + \dfrac{1}{R_{yi}} + \dfrac{1}{R_a + R_b}}} \times PV_i = V_{E12}$$

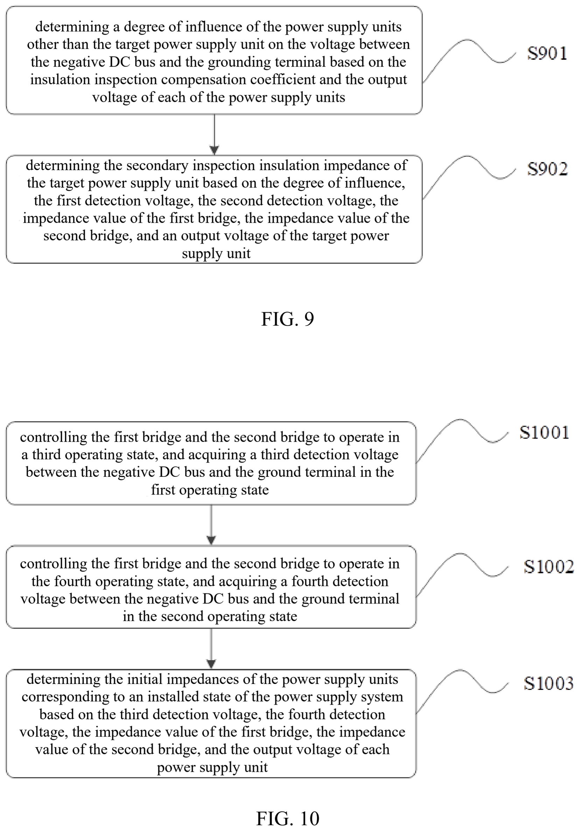

where $V_{E12}$ is the second detection voltage.
It can be seen that during the measurement of the first and second detection voltages, the impedance value of the first bridge 20 remains unchanged, but the impedance value of the second bridge 30 changes (or the impedance value of the first bridge 20 changes, but the impedance value of the second bridge 30 remains unchanged). Therefore, at least one of the first bridge 20 and the second bridge 30 has a different impedance value in the first and second operating states. Furthermore, in the calculation formulas for the first and second detection voltages, the left-hand side of the calculation formulas for the first and second detection voltages (formulas f11 and f12 or f11 and f13) contains only two unknowns, $R_{xi}$ and $R_{yi}$. Therefore, for different power supply units 10, after measuring the first and second detection voltages, it is only necessary to substitute their output voltage $P_{Vi}$ to calculate the insulation impedances $R_{xi}$ and $R_{yi}$ of the power supply unit 10 using the two formulas, thereby ultimately determining the preliminary inspection insulation impedance of each power supply unit 10.
In some embodiments of the present invention, referring to FIG. 9, which shows a schematic diagram of a process for determining the secondary inspection insulation impedance according to an embodiment of the present invention, wherein determining the secondary inspection insulation impedance of the target power supply unit based on the insulation inspection compensation coefficient includes:

S901, determining a degree of influence of the power supply units 10 other than the target power supply unit on the voltage between the negative DC bus BUS- and the ground terminal PE based on the insulation inspection compensation coefficient and the output voltage of each of the power supply units 10; and

S902, determining the secondary inspection insulation impedance of the target power supply unit 10 based on the degree of influence, the first detection voltage, the second detection voltage, the impedance value of the first bridge 20, the impedance value of the second bridge 30, and an output voltage of the target power supply unit 10.

It should be noted that, according to the voltage superposition theorem, the degree of influence of other power supply units 10 besides the target power supply unit 10 on the voltage between the negative DC bus BUS- and the ground terminal PE can be calculated as the algebraic sum of the degrees of the influence of the other power supply units 10 on the voltage between the negative DC bus BUS- and the ground terminal PE. Therefore, the degree of influence of other power supply units 10 besides the target power supply unit 10 on the voltage between the negative DC bus BUS- and the ground terminal PE can be calculated by:

$$\frac{1}{k_{eq}} \times \frac{1}{5} \times \left( \sum_{i=1}^{6} PV_i - PV_0 \right)$$

wherein $P_{V0}$ is the output voltage of the target power supply unit 10.

After determining the degree of influence of other power supply units 10 on the voltage between the negative DC bus BUS- and the ground terminal PE, the degree of influence can be substituted into the above formulas f11 and f12 (or f11 and f13), and the secondary inspection insulation impedance corresponding to the target power supply unit 10 can be determined based on the output voltage of the target power supply unit 10.

For example, if we substitute these equations into the formulas f11 and f12 above, we can obtain two equations:

$$\frac{1}{k_{eq}} \times \frac{1}{5} \times \left( \sum_{i=1}^{6} PV_i - PV_0 \right) + \frac{\dfrac{1}{\dfrac{1}{R_{x0}} + \dfrac{1}{R_{y0}} + \dfrac{1}{R_a}}}{R_a + \dfrac{1}{\dfrac{1}{R_{x0}} + \dfrac{1}{R_{y0}} + \dfrac{1}{R_a}}} \times V_{bus} + \frac{\dfrac{1}{\dfrac{1}{R_a} + \dfrac{1}{R_{y0}} + \dfrac{1}{R_a}}}{R_{x0} + \dfrac{1}{\dfrac{1}{R_a} + \dfrac{1}{R_{y0}} + \dfrac{1}{R_a}}} \times PV_0 = V_{E10}$$

$$\frac{1}{k_{eq}} \times \frac{1}{5} \times \left( \sum_{i=1}^{6} PV_i - PV_0 \right) + \frac{\dfrac{1}{\dfrac{1}{R_{x0}} + \dfrac{1}{R_{y0}} + \dfrac{1}{R_a + R_b}}}{R_a + \dfrac{1}{\dfrac{1}{R_{x0}} + \dfrac{1}{R_{y0}} + \dfrac{1}{R_a + R_b}}} \times V_{bus} + \frac{\dfrac{1}{\dfrac{1}{R_a} + \dfrac{1}{R_{y0}} + \dfrac{1}{R_a + R_b}}}{R_{x0} + \dfrac{1}{\dfrac{1}{R_a} + \dfrac{1}{R_{y0}} + \dfrac{1}{R_a + R_b}}} \times PV_0 = V_{E11}$$

where $R_{x0}$ and $R_{x0}$ are the insulation impedances of the target power supply unit 10.

It can be seen that the degree of influence of other power supply units 10 (excluding the target power supply unit 10) on the voltage between the negative DC bus BUS- and the ground terminal PE is a correction of the above formulas f11, f12, and f13. Each formula also contains two unknowns, $R_{x0}$ and $R_{y0}$. Therefore, by simultaneously solving the above two formulas, the secondary inspection insulation impedance $R_{x0}$ and $R_{y0}$ corresponding to the target power supply unit 10 can be determined. Furthermore, since the secondary inspection insulation impedance is the impedance value determined by compensating for the influence of other power supply units 10 on the voltage between the negative DC bus BUS- and the ground terminal PE based on the insulation inspection compensation coefficient, the measurement accuracy of the insulation impedance of the target power supply unit 10 can ultimately be guaranteed.

In some embodiments of the present invention, for example, in an embodiment where the first bridge 20 includes a first resistor, a second resistor, and a first switch $S_1$, and the second bridge 30 includes a third resistor, a fourth resistor, and a second switch $S_2$, when the first bridge 20 and the second bridge 30 are controlled to operate in the first operating state, the first switch $S_1$ and the second switch $S_2$ have the same switching state; when the first bridge 20 and the second bridge 30 are controlled to operate in the second operating state, the first switch $S_1$ and the second switch $S_2$ have different

switching states.

For example, when the first bridge 20 and the second bridge 30 are operating in the first operating state, both the first switch $S_1$ and the second switch $S_2$ are in the close state. However, when the first bridge 20 and the second bridge 30 are operating in the second operating state, one of the first switch $S_1$ and the second switch $S_2$ is in the close state, while the other is in the open state. For another example, when the first bridge 20 and the second bridge 30 are operating in the first operating state, both the first switch $S_1$ and the second switch $S_2$ are in the open state; when the first bridge 20 and the second bridge 30 are operating in the second operating state, one of the first switch $S_1$ and the second switch $S_2$ is in the closed state, while the other is in the open state.

In some embodiments of the present invention, when the first bridge 20 and the second bridge 30 are operating in the first operating state, the first switch $S_1$ and the second switch $S_2$ are in the closed state; when the first detection voltage is greater than half the bus voltage, and when the first bridge 20 and the second bridge 30 are operating in the second operating state, the first switch $S_1$ remains in the closed state, and the second switch $S_2$ changes to the open state; when the first detection voltage is less than half the bus voltage $0.5V_{bus}$, and when the first bridge 20 and the second bridge 30 are operating in the second operating state, the first switch $S_1$ changes to the open state, and the second switch $S_2$ remains in the closed state.

It should be noted that when the first detection voltage is greater than half the bus voltage, and when the first bridge 20 and the second bridge 30 are operating in the second operating state, the first switch $S_1$ remains closed and the second switch $S_2$ is opened. In this case, the impedance of the second bridge 30 connected between the negative DC bus BUS- and the ground terminal PE increases, which can cause a significant difference between the second measured voltage and the first measured voltage. Similarly, when the first detection voltage is less than half the bus voltage, and when the first bridge 20 and the second bridge 30 are operating in the second operating state, the first switch $S_1$ is opened, and the second switch $S_2$ remains closed. In this case, the impedance of the second bridge 30 connected between the positive DC bus BUS+ and the ground terminal PE increases, which can also cause a significant difference between the second measured voltage and the first measured voltage.

As can be seen, in the above embodiments, regardless of whether the first detection voltage is greater than or less than half the bus voltage, the control logic of the above embodiments can make the second measurement voltage significantly different from the first measurement voltage, thereby helping to reduce the impact of voltage sampling accuracy on the detection result and ultimately ensuring the accuracy of insulation impedance detection.

In some embodiments of the present invention, when the first bridge 20 and the second bridge 30 are controlled to operate in the first operating state, the first switch $S_1$ and the second switch $S_2$ are in the open state; when the first detection voltage is greater than half bus voltage, i.e., $0.5V_{bus}$, and when the first bridge 20 and the second bridge 30 are controlled to operate in the second operating state, the first switch $S_1$ remains in the open state, and the second switch $S_2$ changes to the closed state; when the first detection voltage is less than half bus voltage $0.5V_{bus}$, and when the first bridge 20 and the second bridge 30 are controlled to operate in the second operating state, the first switch $S_1$ changes to the closed state, and the second switch $S_2$ remains in the open state.

Similarly, when the first detection voltage is greater than half the bus voltage, i.e., $0.5V_{bus}$, and when the first bridge 20 and the second bridge 30 are controlled to operate in the second operating state, the first switch $S_1$ remains open, and the second switch $S_2$ changes to be closed. The impedance of the second bridge 30 connected between the negative DC bus BUS- and the ground terminal PE decreases, which can cause a significant difference between the second measured voltage and the first measured voltage. Likewise, when the first detection voltage is less than half the bus voltage, i.e., $0.5V_{bus}$, and when the first bridge 20 and the second bridge 30 are controlled to operate in the second operating state, the first switch $S_1$ changes to be closed, and the second switch $S_2$ remains open. The impedance of the second bridge 30 connected between the positive DC bus BUS+ and the ground terminal PE decreases, which can also cause a significant difference between the second measured voltage and the first measured voltage.

Therefore, regardless of whether the first detection voltage is greater than or less than half the bus voltage, the control logic of the above embodiment can make the second measured voltage significantly different from the first measured voltage, thereby helping to reduce the impact of voltage sampling accuracy on the detection result and ensuring the accuracy of insulation impedance detection.

In some embodiments of the present invention, before determining the preliminary inspection insulation impedance of each power supply unit 10, referring to FIG. 10, which shows a schematic diagram of a process for determining the initial impedance according to an embodiment of the present invention. The method for insulation impedance detection of the present invention further includes:

S1001, controlling the first bridge 20 and the second bridge 30 to operate in a third operating state, and acquiring a third detection voltage between the negative DC bus BUS- and the ground terminal PE in the first operating state;
S1002, controlling the first bridge 20 and the second bridge 30 to operate in the fourth operating state, and acquiring a fourth detection voltage between the negative DC bus BUS- and the ground terminal PE in the second operating state; and

S1003, determining the initial impedances of the power supply units 10 corresponding to an installed state of the power supply system based on the third detection voltage, the fourth detection voltage, the impedance value of the first bridge 20, the impedance value of the second bridge 30, and the output voltage of each power supply unit 10.

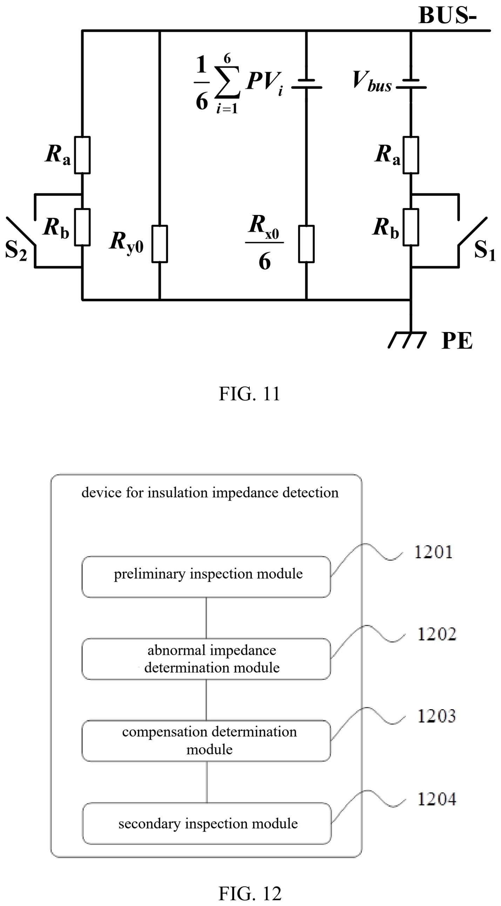

It should be noted that the initial impedance of power supply unit 10 refers to the insulation impedance measured after the power supply unit 10 is installed on site. After installation, the insulation impedance of power supply unit 10 is normal, and the impedance of each power supply unit 10 is equal. During the measurement of initial impedance, the switching transistors are not operating. Therefore, according to Thevenin's theorem, FIG. 1 can be converted into the equivalent circuit diagram shown in FIG. 11. Furthermore, since at least one of the first bridge 20 and the second bridge 30 has different impedance values in the third and fourth operating states, the third detection voltage and the fourth detection voltage are also different. Therefore, two equations can be constructed for each power supply unit 10, and the initial impedance after machine installation can be solved.

In an example as shown in FIG. 11, assuming that the first switch $S_1$ of the first bridge 20 is closed and the second switch $S_2$ of the second bridge 30 is open, then the measured third detection voltage can be calculated according to the following formula:

$$f_{01}: \quad \frac{\dfrac{1}{\dfrac{1}{R_{y0}}+\dfrac{1}{R_a+R_b}+\dfrac{6}{R_{x0}}}}{R_a+\dfrac{1}{\dfrac{1}{R_{y0}}+\dfrac{1}{R_a+R_b}+\dfrac{6}{R_{x0}}}}\times V_{bus}+\frac{\dfrac{1}{\dfrac{1}{R_{y0}}+\dfrac{1}{R_a+R_b}+\dfrac{1}{R_a}}}{\dfrac{R_{x0}}{6}+\dfrac{1}{\dfrac{1}{R_{y0}}+\dfrac{1}{R_a+R_b}+\dfrac{1}{R_a}}}\times\frac{1}{6}\sum_{i=1}^{6}PV_i=V_{E01}$$

In the above formula, $V_{E01}$ is the third detection voltage, and $R_{x0}$ and $R_{x0}$ are the initial impedances.

Assuming that the first switch $S_1$ of the first bridge 20 is closed and the second switch $S_2$ of the second bridge 30 is closed, then the measured second detection voltage can be calculated according to the following formula:

$$f_{02}: \quad \frac{\dfrac{1}{\dfrac{1}{R_{y0}}+\dfrac{1}{R_a}+\dfrac{6}{R_{x0}}}}{R_a+\dfrac{1}{\dfrac{1}{R_{y0}}+\dfrac{1}{R_a}+\dfrac{6}{R_{x0}}}}\times V_{bus}+\frac{\dfrac{1}{\dfrac{1}{R_{y0}}+\dfrac{1}{R_a}+\dfrac{1}{R_a}}}{\dfrac{R_{x0}}{6}+\dfrac{1}{\dfrac{1}{R_{y0}}+\dfrac{1}{R_a}+\dfrac{1}{R_a}}}\times\frac{1}{6}\sum_{i=1}^{6}PV_i=V_{E02}$$

In the above formula, $V_{E02}$ is the fourth detection voltage.

It can be seen that the above formulas $f_{01}$ and $f_{02}$ only have two unknowns, $R_{x0}$ and $R_{y0}$. Therefore, after measuring the third and fourth detection voltages, the initial impedances of the power supply units 10 corresponding to an installed state of the power supply system can be determined by solving the equations simultaneously.

It should be noted that any calculation formulas in this invention are merely exemplary calculation methods and do not constitute a limitation of the claims of this invention. Those skilled in the art can make equivalent modifications to the above calculation formulas under the guidance of this invention. For example, if both the first switch $S_1$ and the second switch $S_2$ are open when measuring the third detection voltage, and the first switch $S_1$ is open and the second switch $S_2$ is closed when measuring the fourth detection voltage, then the above formulas $f_{01}$ and $f_{02}$ can be modified as follows:

$$f_{01}: \quad \frac{\dfrac{1}{\dfrac{1}{R_{y0}}+\dfrac{1}{R_a+R_b}+\dfrac{6}{R_{x0}}}}{R_a+R_b+\dfrac{1}{\dfrac{1}{R_{y0}}+\dfrac{1}{R_a+R_b}+\dfrac{6}{R_{x0}}}}\times V_{bus}+\frac{\dfrac{1}{\dfrac{1}{R_{y0}}+\dfrac{1}{R_a+R_b}+\dfrac{1}{R_a+R_b}}}{\dfrac{R_{x0}}{6}+\dfrac{1}{\dfrac{1}{R_{y0}}+\dfrac{1}{R_a+R_b}+\dfrac{1}{R_a+R_b}}}\times\frac{1}{6}\sum_{i=1}^{6}PV_i=V_{E01}$$

$$f_{02}: \quad \frac{\dfrac{1}{\dfrac{1}{R_{y0}}+\dfrac{1}{R_a}+\dfrac{6}{R_{x0}}}}{R_a+R_b+\dfrac{1}{\dfrac{1}{R_{y0}}+\dfrac{1}{R_a}+\dfrac{6}{R_{x0}}}}\times V_{bus}+\frac{\dfrac{1}{\dfrac{1}{R_{y0}}+\dfrac{1}{R_a}+\dfrac{1}{R_a+R_b}}}{\dfrac{R_{x0}}{6}+\dfrac{1}{\dfrac{1}{R_{y0}}+\dfrac{1}{R_a}+\dfrac{1}{R_a+R_b}}}\times\frac{1}{6}\sum_{i=1}^{6}PV_i=V_{E02}$$

For example, the insulation inspection compensation coefficient of the present invention can also be calculated according to one of the following two formulas:

$$k_{eq}=1+\frac{\dfrac{R_{x0}}{5}}{\dfrac{1}{\dfrac{1}{R_{xi}}+\dfrac{1}{R_{yi}}+\dfrac{1}{R_a+R_b}+\dfrac{1}{R_a+R_b}}}$$

$$k_{eq}=1+\frac{\dfrac{R_{x0}}{5}}{\dfrac{1}{\dfrac{1}{R_{xi}}+\dfrac{1}{R_{yi}}+\dfrac{1}{R_a}+\dfrac{1}{R_a+R_b}}}$$

Furthermore, to better implement the method for insulation impedance detection in the embodiments of the present invention, the present invention also provides a device for insulation impedance detection. Referring to FIG. 12, which shows a schematic diagram of a device for insulation impedance detection according to an embodiment of the present invention, wherein the device for insulation impedance detection includes:

a preliminary inspection module 1201 configured to determine a preliminary inspection insulation impedance of each power supply unit 10;
an abnormal impedance determination module 1202 configured to determine a preliminary inspection insulation impedance that meets a preset condition as the target insulation impedance of the target power supply unit 10 based on the preliminary inspection insulation impedance of each power supply unit 10;
a compensation determination module 1203 configured to determine a insulation inspection compensation coefficient based on the target insulation impedance and initial impedances of the power supply units 10; and
a secondary inspection module 1204 configured to determine a secondary inspection insulation impedance corresponding to the target power supply unit 10 based on the insulation inspection compensation coefficient;
wherein the preliminary inspection insulation impedance of any power supply unit 10 is determined by assuming that the voltage between the negative DC bus BUS- and the ground terminal PE is only affected by the power supply unit 10. The secondary inspection insulation impedance is determined by compensating for the influence of other power supply units 10 on the voltage between the negative DC bus BUS- and the ground terminal PE based on the insulation inspection compensation coefficient.

It should be understood that the device and its modules shown in FIG. 12 can be implemented in various ways. For example, in some embodiments, the device and its modules can be implemented by hardware, software, or a combination of software and hardware. The hardware portion can be implemented using dedicated logic; the software portion can be stored in memory and executed by an appropriate instruction execution system, such as a microprocessor or dedicated hardware. Those skilled in the art will understand that the methods and systems described above can also be implemented by a computer program or firmware executed by a processor.

It should be noted that the above description of the device and its modules is for ease of description only and should not limit the invention to the scope of the embodiments described. It is understood that those skilled in the art, after understanding the principle of the system, may arbitrarily combine the various modules or connect them to other modules to form a subsystem without departing from this principle. For example, the preliminary inspection module 1201, abnormal impedance determination module 1202, compensation determination module 1203, and secondary inspection module 1204 disclosed in FIG. 12 can be different modules in one system, or a single module can implement the functions of two or more of the above modules. For example, the preliminary inspection module 1201 and the secondary inspection module 1204 can be two modules respectively having the functions of preliminary inspection of insulation impedance and secondary inspection of insulation impedance, or they can be a single module having both the functions of preliminary inspection of insulation impedance and secondary inspection of insulation impedance.

Furthermore, embodiments of the present invention also provide a system for insulation impedance detection, which includes a memory and a processor. Those skilled in the art will understand that the system for insulation impedance detection may include more or fewer components, or combine certain components, or have different component arrangements.

The processor is the control center of the system. It performs various functions and processes data by running or executing software programs and/or modules stored in memory, and by calling data stored in memory. Optionally, the processor may include one or more processing cores; the processor may be a Central Processing Unit (CPU), or it may be other general-purpose processors, digital signal processors (DSPs), application-specific integrated circuits (ASICs), field-programmable gate arrays (FPGAs), or other programmable logic devices.

The memory can be configured to store software programs and modules. The processor executes various functional applications and data processing by running the software programs and modules stored in the memory. The memory can mainly include a program storage area and a data storage area. In addition, the memory can include volatile memory or non-volatile memory, and may also include a memory controller for the processor to access.

Furthermore, embodiments of the present invention also provide a computer-readable storage medium, which may include: read-only memory (ROM), random access memory (RAM), a magnetic disk, or an optical disk, etc. A computer program is stored thereon, which is loaded by a processor to execute the operations in any of the methods for insulation impedance detection provided in the embodiments of the present invention. For example, the computer program loaded by the processor can execute the following operations:

determining a preliminary inspection insulation impedance of each power supply unit 10;
determining a preliminary inspection insulation impedance that meets a preset condition as a target insulation impedance based on the preliminary inspection insulation impedance of each power supply unit 10;
determining an insulation inspection compensation coefficient based on the target insulation impedance and initial impedance of the power supply units 10; and
determining a secondary inspection insulation impedance of the target power supply unit 10 based on the insulation inspection compensation coefficient;
wherein the preliminary inspection insulation impedance of any power supply unit 10 is determined by assuming that the voltage between the negative DC bus BUS- and the ground terminal PE is only affected by the power supply unit 10. The secondary inspection insulation impedance is determined by compensating for the influence of other power supply units 10 on the voltage between the negative DC bus BUS- and the ground terminal PE based on the insulation inspection compensation coefficient.

In the above embodiments, the descriptions of each embodiment have different focuses. For parts not described in detail in a certain embodiment, please refer to the detailed descriptions of other embodiments above, which will not be repeated here.

The basic concepts have been described above. It is clear that the detailed disclosure above is merely illustrative and does not constitute a limitation of the present invention. Although not explicitly stated herein, various modifications, improvements, and corrections may be made to the present invention by those skilled in the art. Such modifications, improvements, and corrections are suggested in this invention and therefore remain within the spirit and scope of the exemplary embodiments of the present invention.

Meanwhile, specific terms are used to describe embodiments of the invention. For example, "an embodiment," "one embodiment," and/or "some embodiments" refer to a particular feature, structure, or characteristic related to at least one embodiment of the invention. Therefore, it should be emphasized and noted that "an embodiment," "one embodiment," or "an alternative embodiment" mentioned twice or more in different locations in this description do not necessarily refer to the same embodiment. Furthermore, certain features, structures, or characteristics in one or more embodiments of the invention can be appropriately combined.

The above provides a detailed description of a method, device, system, and storage medium for insulation impedance detection provided by embodiments of the present invention. Specific examples have been used to illustrate the principles and implementation methods of the present invention. The descriptions of the above embodiments are only for the purpose of helping to understand the method and core ideas of the present invention. At the same time, those skilled in the art will recognize that there will be changes in the specific implementation methods and application scope based on the ideas of the present invention. Therefore, the content of this specification should not be construed as a limitation of the present invention.

**Claims**

1. A method for insulation impedance detection, applicable to a power supply system comprising a plurality of power supply units (10) connected in parallel between a positive direct current (DC) bus (BUS+) and a negative DC bus (BUS-), **characterized in that** the method comprises:

   determining (S501) a preliminary inspection insulation impedance of each of the power supply units;
   determining (S502) a preliminary inspection insulation impedance that meets a preset condition as a target insulation impedance based on the preliminary inspection insulation impedance of each of the power supply units;
   determining (S503) an insulation inspection compensation coefficient based on the target insulation impedance and initial impedances of the plurality of power supply units; and
   determining (S504) a secondary inspection insulation impedance of a target one of the power supply units based on the insulation inspection compensation coefficient;
   wherein the preliminary inspection insulation impedance of any of the power supply units has an impedance value determined on an assumption that a voltage between the negative DC bus and a ground terminal (PE) is only influenced by the power supply unit;
   the secondary inspection insulation impedance has an impedance value determined by the insulation inspection compensation coefficient compensating for an influence of other ones of the power supply units on the voltage between the negative DC bus and the ground terminal (PE).

2. The method for insulation impedance detection according to claim 1, wherein the power supply system further comprises a first bridge (20) connected between the positive DC bus (BUS+) and the ground terminal (PE), and a second bridge (30) connected between the negative DC bus (BUS-) and the ground terminal (PE);
   wherein the determining (S501) of the preliminary inspection insulation impedance of each of the power supply units comprises:

   controlling (S801) the first bridge and the second bridge to operate in a first operating state, and acquiring a first detection voltage between the negative DC bus and the ground terminal in the first operating state;
   controlling (S802) the first bridge and the second bridge to operate in a second operating state, and acquiring a second detection voltage between the negative DC bus and the ground terminal in the second operating state; and
   determining (S803) the preliminary inspection insulation impedance of each of the power supply units based on the first detection voltage, the second detection voltage, an impedance value of the first bridge, an impedance value of the second bridge, and an output voltage of each of the power supply units;
   wherein an impedance value of at least one of the first bridge or the second bridge in the first operating state is different from that in the second operating state.

3. The method for insulation impedance detection according to claim 2, wherein the determining (S504) of the secondary inspection insulation impedance of the target power supply unit based on the insulation inspection compensation coefficient comprises:

determining (S901) a degree of influence of the power supply units other than the target power supply unit on the voltage between the negative DC bus and the ground terminal based on the insulation inspection compensation coefficient and the output voltage of each of the power supply units; and

determining (S902) the secondary inspection insulation impedance of the target power supply unit based on the degree of influence, the first detection voltage, the second detection voltage, the impedance value of the first bridge, the impedance value of the second bridge, and an output voltage of the target power supply unit.

4. The method for insulation impedance detection according to claim 2, wherein

the first bridge comprises a first resistor and a second resistor connected in series between the positive DC bus (BUS+) and the ground terminal (PE), and a first switch ($S_1$) connected in parallel with the second resistor;

the second bridge comprises a third resistor and a fourth resistor connected in series between the negative DC bus (BUS-) and the ground terminal (PE), and a second switch ($S_2$) connected in parallel with the fourth resistor;

wherein a switching state of at least one of the first switch or the second switch in the first operating state is different from that in the second operating state.

5. The method for insulation impedance detection according to claim 4, wherein

when the first bridge and the second bridge are controlled to operate in the first operating state, the switching states of the first switch and the second switch are the same;

when the first bridge and the second bridge are controlled to operate in the second operating state, the switching states of the first switch and the second switch are different.

6. The method for insulation impedance detection according to claim 5, wherein

when the first bridge and the second bridge are controlled to operate in the first operating state, the first switch and the second switch are in a closed state;

when the first detection voltage is greater than half of a bus voltage, and when the first bridge and the second bridge are controlled to operate in the second operating state, the first switch remains in the closed state and the second switch is changed to an open state;

when the first detection voltage is less than half of the bus voltage, and when the first bridge and the second bridge are controlled to operate in the second operating state, the first switch is changed to the open state, and the second switch remains in the closed state.

7. The method for insulation impedance detection according to claim 5, wherein

when the first bridge and the second bridge are controlled to operate in the first operating state, the first switch and the second switch are in an open state;

when the first detection voltage is greater than half of a bus voltage, and when the first bridge and the second bridge are controlled to operate in the second operating state, the first switch remains in the open state and the second switch is changed to a closed state;

when the first detection voltage is less than half of the bus voltage, and when the first bridge and the second bridge are controlled to operate in the second operating state, the first switch is changed to the closed state and the second switch remains in the open state.

8. The method for insulation impedance detection according to claim 1, wherein prior to the determining (S501) of the preliminary inspection insulation impedance of each of the power supply units, the method further comprises:

controlling (S1001) the first bridge and the second bridge to operate in a third operating state, and acquiring a third detection voltage between the negative DC bus and the ground terminal in the first operating state;

controlling (S1002) the first bridge and the second bridge to operate in a fourth operating state, and acquiring a fourth detection voltage between the negative DC bus and the ground terminal in the second operating state; and

determining (S1003) the initial impedances of the power supply units corresponding to an installed state of the power supply system based on the third detection voltage, the fourth detection voltage, the impedance value of the first bridge, the impedance value of the second bridge, and the output voltage of each of the power supply units.

9. The method for insulation impedance detection according to claim 1, wherein the determining (S502) of the preliminary inspection insulation impedance that meets the preset condition as the target insulation impedance based on the preliminary inspection insulation impedance of each of the power supply units comprises:

determining a smallest one among the preliminary inspection insulation impedances of the plurality of power supply units as the target insulation impedance.

10. A device for insulation impedance detection, **characterized by** comprising:

a preliminary inspection module (1201) configured to determine a preliminary inspection insulation impedance of each of the power supply units;

an abnormal impedance determination module (1202) configured to determine a preliminary inspection insulation impedance that meets a preset condition as a target insulation impedance based on the preliminary inspection insulation impedance of each of the power supply units;

a compensation determination module (1203) configured to determine an insulation inspection compensation coefficient based on the target insulation impedance and initial impedances of the power supply units; and

a secondary inspection module (1204) configured to determine a secondary inspection insulation impedance of a target power supply unit based on the insulation inspection compensation coefficient;

wherein the preliminary inspection insulation impedance of any of the power supply units has an impedance value determined on an assumption that a voltage between the negative DC bus and a ground terminal (PE) is only influenced by the power supply unit;

the secondary inspection insulation impedance has an impedance value determined by the insulation inspection compensation coefficient compensating for an influence of other ones of the power supply units on the voltage between the negative DC bus and the ground terminal (PE).

11. A system for insulation impedance detection, **characterized by** comprising a memory and a processor, the memory having stored thereon computer programs, which when executed by the processor, cause the processor to implement the method for insulation impedance detection according to any one of claims 1 to 9.

12. A storage medium, **characterized by** having stored thereon a plurality of instructions executable by a processor, wherein the instructions when executed by the processor cause the processor to implement the method for insulation impedance detection according to any one of claims 1 to 9.

FIG. 1

FIG. 2

FIG. 3

FIG. 4

```
┌─────────────────────────────────────────────┐
│                                             │        S501
│ determining a preliminary inspection        │ ╭───┐
│ insulation impedance of each power supply   │ ⟋    
│ unit                                        │
└─────────────────────────────────────────────┘
                      │
                      ▼
┌─────────────────────────────────────────────┐
│ determining a preliminary inspection        │        S502
│ insulation impedance that meets a preset    │ ╭───┐
│ condition as a target insulation impedance  │ ⟋
│ based on the preliminary inspection         │
│ insulation impedance of each power supply   │
│ unit                                        │
└─────────────────────────────────────────────┘
                      │
                      ▼
┌─────────────────────────────────────────────┐
│ determining an insulation inspection        │        S503
│ compensation coefficient of the target      │ ╭───┐
│ power supply unit based on the target       │ ⟋
│ insulation impedance and the initial        │
│ impedances of the power supply units        │
└─────────────────────────────────────────────┘
                      │
                      ▼
┌─────────────────────────────────────────────┐
│ determining a secondary inspection          │        S504
│ insulation impedance corresponding to the   │ ╭───┐
│ target power supply unit based on the       │ ⟋
│ insulation inspection compensation          │
│ coefficient                                 │
└─────────────────────────────────────────────┘
```

FIG. 5

FIG. 6

FIG. 7

controlling the first bridge and the second bridge to operate in a first operating state, and acquiring a first detection voltage between the negative DC bus and the ground terminal in the first operating state

S801

controlling the first bridge and the second bridge to operate in a second operating state, and acquiring a second detection voltage between the negative DC bus and the ground terminal in the second operating state

S802

determining the preliminary inspection insulation impedance of each of the power supply units based on the first detection voltage, the second detection voltage, an impedance value of the first bridge, an impedance value of the second bridge, and an output voltage of each power supply unit

S803

FIG. 8

determining a degree of influence of the power supply units other than the target power supply unit on the voltage between the negative DC bus and the grounding terminal based on the insulation inspection compensation coefficient and the output voltage of each of the power supply units ⟶ S901

determining the secondary inspection insulation impedance of the target power supply unit based on the degree of influence, the first detection voltage, the second detection voltage, the impedance value of the first bridge, the impedance value of the second bridge, and an output voltage of the target power supply unit ⟶ S902

FIG. 9

controlling the first bridge and the second bridge to operate in a third operating state, and acquiring a third detection voltage between the negative DC bus and the ground terminal in the first operating state ⟶ S1001

controlling the first bridge and the second bridge to operate in the fourth operating state, and acquiring a fourth detection voltage between the negative DC bus and the ground terminal in the second operating state ⟶ S1002

determining the initial impedances of the power supply units corresponding to an installed state of the power supply system based on the third detection voltage, the fourth detection voltage, the impedance value of the first bridge, the impedance value of the second bridge, and the output voltage of each power supply unit ⟶ S1003

FIG. 10

FIG. 11

FIG. 12

| | Europäisches Patentamt / European Patent Office / Office européen des brevets | **EUROPEAN SEARCH REPORT** | Application Number |
| --- | --- | --- | --- |
| | | | EP 25 22 0365 |

## DOCUMENTS CONSIDERED TO BE RELEVANT

| Category | Citation of document with indication, where appropriate, of relevant passages | Relevant to claim | CLASSIFICATION OF THE APPLICATION (IPC) |
| --- | --- | --- | --- |
| A | CN 114 696 743 A (JINJIAOSHI SCIENCE AND TECH SHARE LIMITED COMPANY) 1 July 2022 (2022-07-01) * paragraph [0010] - paragraph [0019] * * paragraph [0035] - paragraph [0052] * * figures 1-4 * | 1-12 | INV. G01R27/02 G01R27/18 G01R31/52 ADD. H02S50/10 |
| A | US 2023/402972 A1 (LIN JIANFEI [CN] ET AL) 14 December 2023 (2023-12-14) * paragraph [0086] - paragraph [0157] * * figures 5-14 * | 1-12 | |
| A | CN 117 240 214 A (GINLONG TECH CO LTD) 15 December 2023 (2023-12-15) * paragraph [0070] - paragraph [0104] * * figures 1-7 * | 1-12 | |
| A | CN 108 427 038 A (ZTE QUANTUM CO LTD) 21 August 2018 (2018-08-21) * abstract * * figure 1 * | 1-12 | TECHNICAL FIELDS SEARCHED (IPC) G01R H02S |

The present search report has been drawn up for all claims

| Place of search | Date of completion of the search | Examiner |
| --- | --- | --- |
| Munich | 23 April 2026 | Paraf, Edouard |

## ANNEX TO THE EUROPEAN SEARCH REPORT
## ON EUROPEAN PATENT APPLICATION NO.

EP 25 22 0365

This annex lists the patent family members relating to the patent documents cited in the above-mentioned European search report.
The members are as contained in the European Patent Office EDP file on
The European Patent Office is in no way liable for these particulars which are merely given for the purpose of information.

23-04-2026

| Patent document cited in search report | | Publication date | Patent family member(s) | | Publication date |
|---|---|---|---|---|---|
| CN 114696743 | A | 01-07-2022 | NONE | | |
| US 2023402972 | A1 | 14-12-2023 | CN | 116710787 A | 05-09-2023 |
| | | | EP | 4287504 A1 | 06-12-2023 |
| | | | US | 2023402972 A1 | 14-12-2023 |
| | | | WO | 2022178656 A1 | 01-09-2022 |
| CN 117240214 | A | 15-12-2023 | NONE | | |
| CN 108427038 | A | 21-08-2018 | NONE | | |

EPO FORM P0459

For more details about this annex : see Official Journal of the European Patent Office, No. 12/82